# FASCICULE DE BREVET EUROPEEN

(11) **EP 1 832 884 B1**
(45) Date de publication et mention de la délivrance du brevet: **06.05.2015**
(21) Numéro de dépôt: 07290282.8
(22) Date de dépôt: 06.03.2007
(51) Int. Cl.: G01R 15/04, G01R 19/165, H02G 1/02

(54) **Procédé de détection de tension et détecteur de tension pour le mettre en oeuvre**
Verfahren zum Prüfen der Spannung und Spannungsprüfer zur Umsetzung dieses Verfahrens
Voltage detection method and voltage detector for implementing it

(30) Priorité: 10.03.2006 FR 0650827
(43) Date de publication de la demande: 12.09.2007
(73) Titulaire: Société Anonyme des Ets. CATU, 92220 Bagneux (FR)
(72) Inventeur: Colas, Didier, 77380 Combs la Ville (FR); Bouchez, Bernard, 92220 Bagneux (FR)
(74) Mandataire: Santarelli

(56) Documents cités:
- EP-A1- 0 695 944

## Description

La présente invention concerne le contrôle de la présence d'une tension notamment sur des lignes électriques aériennes haute tension, qu'il s'agisse de lignes de distribution de courant ou de lignes d'alimentation pour réseau ferroviaire.

Avant que des travaux ne soient réalisés par un opérateur sur une ligne électrique, il est nécessaire de vérifier que cette ligne a bien été mise hors tension, c'est-à-dire qu'elle a été déconnectée du reste du réseau électrique.

On utilise pour cela classiquement un détecteur de tension unipolaire (voir par exemple EP 0 695 944) ou bien comportant une électrode de ligne et une électrode de référence, l'électrode de ligne étant reliée à l'électrode de référence par une impédance de mesure que comporte le détecteur de tension.

Pour effectuer le contrôle de la ligne électrique, l'électrode de référence est reliée à la terre ou à la masse voire à un autre élément au potentiel de référence de la tension à détecter, puis le détecteur est monté à l'extrémité d'une perche. L'opérateur, en tenant la perche à bout de bras, vient au contact de la ligne électrique à contrôler par l'intermédiaire de l'électrode de ligne pour déterminer aux bornes de la résistance de mesure la valeur de la tension entre cette ligne et le potentiel de référence.

Un circuit de détection que comporte le détecteur compare cette valeur à une valeur de tension de seuil de façon à indiquer à l'opérateur, si la valeur mesurée est supérieure à la valeur de seuil, la présence d'une tension sur la ligne et sinon l'absence de tension.

La valeur de l'impédance de mesure (quelques MΩ en général) est choisie pour ne dissiper qu'une faible énergie (au travers de cette impédance) au sein du détecteur pendant la mesure de tension.

L'invention vise à augmenter la fiabilité d'une telle détection.

Elle propose à cet effet un procédé de détection d'une tension entre une ligne électrique aérienne et un potentiel de référence ; comportant :
- l'étape de relier à ladite ligne électrique aérienne et audit potentiel de référence une impédance de mesure ayant une valeur prédéterminée ;
- l'étape de déterminer la valeur de tension de mesure prise par ladite tension alors que ladite ligne électrique est reliée audit potentiel de référence par ladite impédance de mesure ;
- l'étape de comparer ladite valeur de tension de mesure à une valeur de seuil prédéterminée ; et
- si ladite valeur de tension de mesure est inférieure à ladite valeur de seuil, l'étape d'indiquer l'absence de tension sur ladite ligne ;
caractérisé en ce que ledit procédé comporte en outre :
- l'étape de relier une impédance supplémentaire ayant une valeur prédéterminée plus basse que ladite valeur de ladite impédance de mesure à ladite ligne électrique aérienne et audit potentiel de référence à un moment distinct de ladite étape de détermination de ladite valeur de tension de mesure ;
- l'étape de déterminer la valeur de tension supplémentaire prise par ladite tension alors que ladite ligne électrique est reliée audit potentiel de référence par ladite impédance supplémentaire ;
- l'étape de comparer la valeur de tension de mesure à la valeur de tension supplémentaire ; et
- si le ratio de ladite valeur de tension supplémentaire sur ladite valeur de tension de mesure est supérieur ou égal à un coefficient prédéterminé, l'étape d'indiquer la présence d'une tension réelle sur ladite ligne alors que si ledit ratio est inférieur audit coefficient prédéterminé, l'étape d'indiquer la présence d'une tension induite sur ladite ligne.

La double mesure de tension ainsi réalisée permet de distinguer le cas où aucune tension n'est détectée sur la ligne et, lorsqu'une tension est détectée sur cette ligne, le cas où cette tension mesurée est une tension réelle (la ligne contrôlée est encore reliée au réseau électrique) et le cas où cette tension mesurée est une tension induite (la ligne est bien mise hors tension mais une tension résiduelle parasite de valeur importante est induite en raison par exemple de phénomènes capacitifs parasites, provenant de la présence de lignes électriques au voisinage de la ligne à contrôler ou encore de conditions climatiques particulières).

Contrairement à l'impédance utilisée dans le détecteur de l'art antérieur adaptée à dissiper un minimum d'énergie et présentant donc une valeur trop élevée pour discriminer une tension réelle d'une tension induite, dans le détecteur selon l'invention, la mesure à une impédance supplémentaire suffisamment basse entraîne, uniquement dans le cas d'une tension induite, une chute de la valeur prise par cette tension aux bornes de cette impédance supplémentaire.

Ceci permet de distinguer, en comparant cette mesure avec celle réalisée avec une impédance plus élevée, le cas où la tension est réelle (pas de chute de tension entre les deux mesures) et le cas où cette tension est induite (chute de tension à basse impédance).

Certes, la puissance dissipée avec l'impédance supplémentaire est plus importante que dans le cas d'une impédance de mesure conventionnelle, mais cela peut s'effectuer sans dommage en reliant cette impédance à la ligne électrique pendant une courte durée (de façon à réduire l'énergie dissipée) suffisante pour réaliser la mesure de tension.

Cette discrimination entre tension induite et tension réelle permet à l'opérateur de savoir de façon sûre que la ligne aérienne contrôlée est bien déconnectée du reste du réseau électrique, aussi bien dans le cas où aucune tension n'est détectée que dans le cas où une tension induite parasite est détectée.

Sur la base de cette information, il peut alors agir en conséquence pour sécuriser la ligne si celle-ci est hors tension (absence de tension ou tension induite) ou faire le nécessaire pour la mettre hors tension si celle-ci est encore alimentée au moment de la détection (tension réelle).

Selon des caractéristiques préférées, pour des raisons de simplicité, de commodité et d'économie de mise en oeuvre :
- on sélectionne comme dite impédance de mesure une impédance dont la valeur est supérieure à 1 MΩ;
- on sélectionne comme dite impédance supplémentaire une impédance dont la valeur est au moins dix fois plus petite que ladite valeur de ladite impédance de mesure ;
- l'étape de relier ladite impédance de mesure comporte l'étape de sélectionner comme impédance de mesure une impédance comportant au moins deux résistances disposées en série ;
- l'étape de déterminer la valeur de tension de mesure prise par ladite tension alors que ladite ligne électrique est reliée audit potentiel de référence par ladite impédance de mesure comporte l'étape de mesurer la tension aux bornes d'une desdites résistances ;
- le procédé comporte l'étape de mettre en court-circuit au moins l'une desdites résistances de ladite impédance de mesure pour former ladite impédance supplémentaire ;
- l'étape de déterminer la valeur de tension supplémentaire prise par ladite tension alors que ladite ligne électrique est reliée audit potentiel de référence par ladite impédance supplémentaire comporte l'étape de mesurer la tension aux bornes d'une desdites résistances, distincte de chaque résistance mise en court-circuit ;
- l'étape de mettre en court-circuit au moins l'une desdites résistances comporte :
   ■ l'étape de sélectionner un organe de commutation ;
   ■ l'étape de disposer ledit organe de commutation en parallèle de cette résistance à mettre en court-circuit ; et
   ■ l'étape de commander la fermeture dudit organe de commutation ;
- on sélectionne comme dit organe de commutation un organe adapté à supporter une tension supérieure à 1500 Volts en position ouverte ;
- la valeur ou la somme des valeurs de chaque résistance à mettre en court-circuit est supérieure à 1 MΩ ;
- on relie ladite impédance supplémentaire à ladite ligne électrique aérienne et audit potentiel de référence pendant une durée inférieure à 200 ms.

L'invention vise également, sous un deuxième aspect, un dispositif convenant à la mise en oeuvre du procédé exposé ci-dessus, ce dispositif comportant :
- une impédance de mesure ;
- des moyens de liaison de ladite impédance de mesure à ladite ligne électrique aérienne et audit potentiel de référence ;
- des moyens de détermination et de comparaison adaptés à déterminer la valeur de tension de mesure prise par ladite tension alors que ladite ligne électrique est reliée audit potentiel de référence par ladite impédance de mesure et à comparer ladite valeur de tension de mesure à une valeur de seuil prédéterminée ; et
- des moyens de signalisation adaptés à indiquer l'absence de tension sur ladite ligne si ladite valeur de tension de mesure est inférieure à ladite valeur de seuil ;
caractérisé en ce qu'il comporte en outre :
- une impédance supplémentaire ayant une valeur prédéterminée plus basse que ladite valeur de ladite impédance de mesure ;
- des moyens de liaison de ladite impédance supplémentaire à ladite ligne électrique aérienne et audit potentiel de référence ;
et en ce que :
- lesdits moyens de détermination et de comparaison sont également adaptés à :
   ■ relier ladite impédance supplémentaire à ladite ligne électrique aérienne et audit potentiel de référence à un moment distinct du moment où lesdits moyens de détermination et de comparaison déterminent la valeur de ladite tension de mesure ;
   ■ déterminer la valeur de tension supplémentaire prise par ladite tension alors que ladite ligne électrique est reliée audit potentiel de référence par ladite impédance supplémentaire ; et à
   ■ comparer ladite valeur de tension de mesure à ladite valeur de tension supplémentaire ; et
- lesdits moyens de signalisation sont également adaptés à indiquer, si le ratio de ladite valeur de tension supplémentaire sur ladite valeur de tension de mesure est supérieur ou égal à un coefficient prédéterminé, la présence d'une tension réelle sur ladite ligne, et à indiquer, si ledit ratio est inférieur audit coefficient prédéterminé, la présence d'une tension induite sur ladite ligne.

Selon des caractéristiques préférées, pour des raisons de simplicité, de commodité et d'économie de mise en oeuvre:
- ladite impédance de mesure comporte au moins deux résistances disposées en série ;
- lesdits moyens de détermination et de comparaison comportent un organe de commutation adapté à prendre une position où il met en court-circuit au moins l'une des dites résistances pour former ladite impédance supplémentaire ;
- lesdits moyens de détermination et de comparaison comportent un micro-contrôleur adapté à mesurer la tension aux bornes d'une desdites résistances ;
- lesdits moyens de liaison de ladite impédance de mesure à ladite ligne électrique aérienne et audit potentiel de référence et lesdits moyens de liaison de ladite impédance supplémentaire à ladite ligne électrique aérienne et audit potentiel de référence sont identiques ;
- lesdits moyens de liaison comportent une antenne et une platine aimantée ; et/ou
- lesdits moyens de signalisation comportent un premier voyant lumineux adapté à prendre un état prédéterminé pour indiquer l'absence de tension, un deuxième voyant lumineux adapté à prendre un état prédéterminé pour indiquer la présence d'une tension induite, et un troisième voyant lumineux adapté à prendre un état prédéterminé pour indiquer la présence d'une tension réelle.

L'exposé de l'invention sera maintenant poursuivi par la description détaillée d'un exemple de réalisation, donnée ci-après à titre illustratif et non limitatif, à l'appui des dessins annexés. Sur ces dessins :
- la figure 1 est une vue en perspective d'un détecteur de tension conforme à l'invention ;
- la figure 2 est une vue de la façade d'un module de signalisation que comporte ce détecteur ;
- la figure 3 est une représentation schématique d'un circuit électrique que comporte ce détecteur ; et
- la figure 4 est un organigramme suivant lequel est programmé un micro-contrôleur que comporte ce circuit électrique.

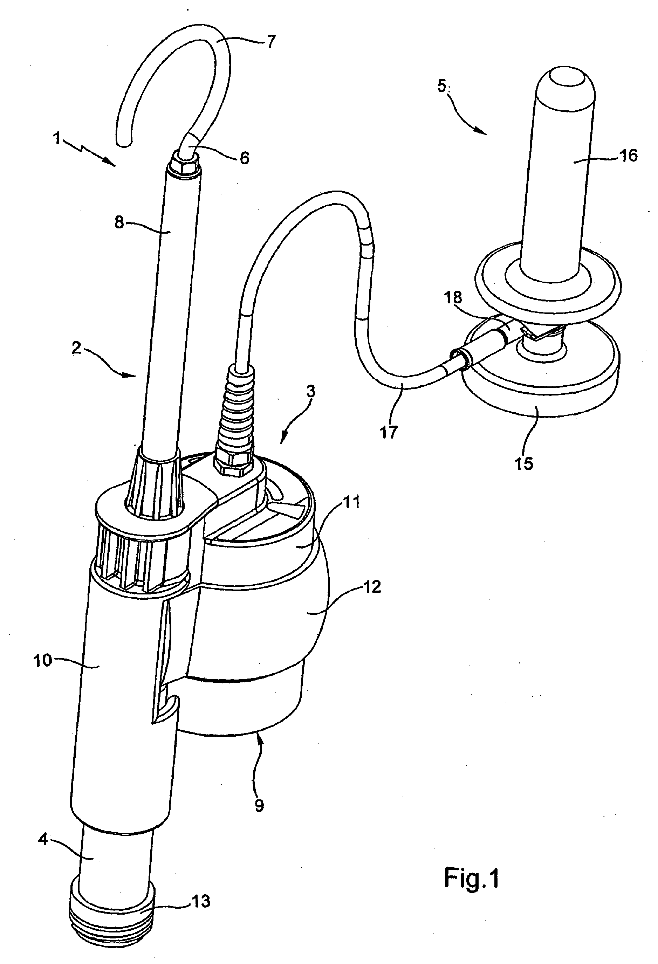

Le détecteur 1 illustré en figure 1 comporte une électrode de ligne, ici une antenne 2, un module de détection et de signalisation 3, un embout 4 et une électrode de référence, ici une électrode de mise à la masse 5.

L'antenne 2 comporte un fourreau cylindrique 8 en matériau isolant et un crochet présentant un tronçon de tige droit 6 et un tronçon de tige recourbé 7.

L'antenne 2 est reliée au module de détection et de signalisation 3.

Ce module présente un premier corps de module 10 et un second corps de module 11 globalement cylindriques.

Le corps de module 10 est situé dans le prolongement de l'antenne 2 entre cette antenne et l'embout 4 tandis que le corps de module 11 est disposé contre le corps de module 10 et est entouré par une ceinture 12.

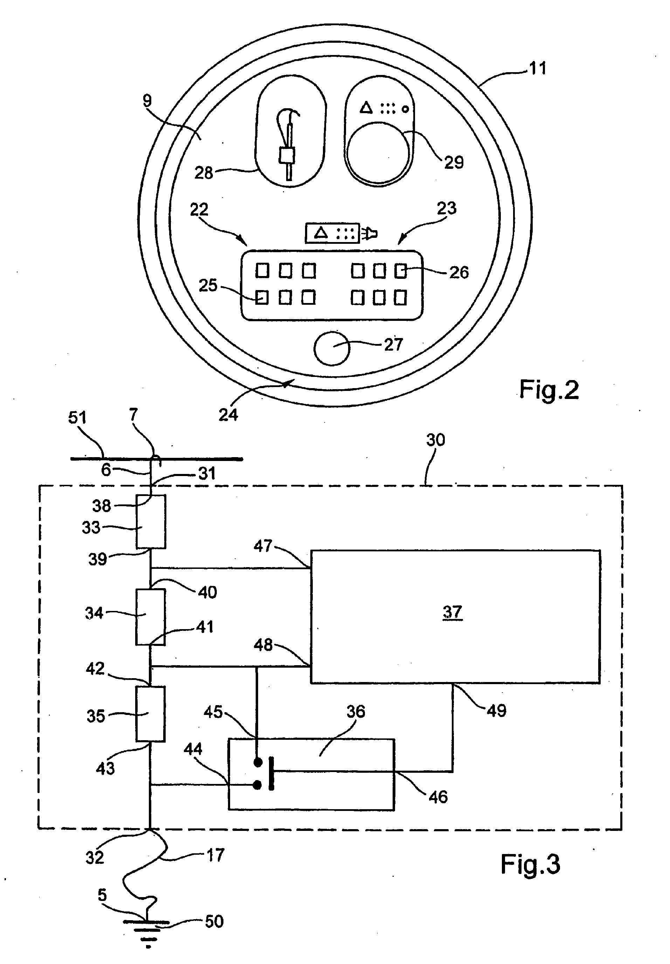

Le corps de module 11 présente une façade 9 sur laquelle sont disposés des éléments de signalisation représentés en figure 2.

L'embout 4 est de forme cylindrique et est adapté à être vissé par un anneau fileté 13 à une perche (non représentée).

L'électrode de mise à la masse 5 comporte une platine aimantée en disque 15, une poignée 16 et un câble électrique 17.

Le câble 17 illustré en figure 1 a été raccourci pour la clarté du dessin (en pratique, un tel câble présente une longueur comprise par exemple entre 5 et 6 mètres).

Ce câble présente à l'une de ses extrémités une cosse 18 enfilée sur une tige (non visible sur la figure 1) montée transversalement sur la platine 15 tandis que l'extrémité opposée de ce câble est reliée au corps de module 11.

La poignée 16 est également vissée sur la tige montée sur la platine 15.

L'antenne 2 ainsi que le conducteur disposé à l'intérieur du câble 17 sont reliés électriquement aux bornes d'un circuit électrique 30 (figure 3) disposé à l'intérieur du fourreau 8 et du module de détection et de signalisation 3.

La façade 9 du module 3, représentée en figure 2, comporte un voyant lumineux 22, un voyant 23 et un voyant 24.

Le voyant 22 comporte trois paires de diodes rouges 25, le voyant 23 comporte trois paires de diodes 26 vertes tandis que le voyant 24 est formé d'une unique diode orange 27.

On va maintenant décrire le circuit électrique 30 à l'aide de la figure 3.

Ce circuit de détection 30 comporte un point de connexion 31 relié à l'antenne 2 et un point de connexion 32 relié au câble 17 menant à la platine 15.

Le circuit de détection comporte également une résistance 33, une résistance 34 et une résistance 35 ainsi qu'un commutateur 36 et un micro-contrôleur 37.

La résistance 33 a une valeur d'environ 400 kΩ, la résistance 34 a une valeur plus faible (de quelque dizaines de kΩ) et la résistance 35 a une valeur d'environ 3.6 MΩ.

La résistance 33 présente deux points de connexion 38 et 39, la résistance 34 présente deux points de connexion 40 et 41, et la résistance 35 présente deux points de connexion 42 et 43. Le commutateur 36 présente trois points de connexion 44, 45 et 46, tandis que le micro-contrôleur 37 présente plusieurs points de connexion dont trois (les points de connexion 47, 48 et 49) sont représentés en figure 3.

Les voyants 22, 23 et 24 sont reliés par des conducteurs (non représentés) à des points de connexion (non représentés) du micro-contrôleur 37.

Le point de connexion 38 de la résistance 33 est relié au point de connexion 31 du circuit 30 tandis que le point de connexion 39 de cette résistance est relié au point de connexion 40 de la résistance 34. Les points de connexion 39 et 40 reliés entre eux sont également reliés au point de connexion 47 du micro-contrôleur 37.

Le point de connexion 41 de la résistance 34 est relié au point de connexion 42 de la résistance 35. Les points de connexion 41 et 42 reliés entre eux sont également reliés au point de connexion 48 du micro-contrôleur 37 et au point de connexion 45 du commutateur 36.

Le point de connexion 43 de la résistance 35 est relié au point de connexion 32 du circuit 30. Les points de connexion 43 et 32 reliés entre eux sont également reliés au point de connexion 44 du commutateur 36. Le point de connexion 45 de ce commutateur est relié au point de connexion 48 du micro-contrôleur et aux points de connexion 41 et 42 des résistances 34 et 35 tandis que le point de connexion 46 de ce commutateur est relié au point de connexion 49 du micro-contrôleur 37.

Les résistances 33, 34 et 35 sont ainsi disposées en série entre les points de connexion 31 et 32, le commutateur 36 étant monté en parallèle de la résistance 35.

Le micro-contrôleur est un micro-contrôleur commercialisé sous la référence PIC 16F870. Le commutateur est un relais qui est ouvert en l'absence de sollicitation et est commercialisé sous la référence SAR 605 SD et est adapté à supporter des tensions élevées à ses bornes (jusqu'à 5000 V) pour des puissances pouvant monter jusqu'à 10 W.

On va maintenant décrire le fonctionnement du détecteur de tension.

Dans l'exemple illustré, le détecteur est utilisé pour détecter une tension sur une ligne électrique ferroviaire alimentée en courant continu sous une tension de fonctionnement de l'ordre de 1500 V.

Dans un premier temps, l'opérateur vérifie le bon fonctionnement du détecteur en mettant au contact l'électrode 5 avec le crochet 2 (comme indiqué sur le dessin représenté dans la zone 28 de la façade 9) et en appuyant sur le bouton de test 29. Le détecteur indique alors à l'opérateur par un signal sonore et lumineux s'il est ou non en état de fonctionnement.

Une fois ce test réalisé, l'opérateur saisit par la poignée 16 l'électrode de masse 5 et la met au contact d'un des rails 50 de la voie ferrée, la platine 15 se plaquant contre le rail métallique par aimantation.

L'opérateur suspend ensuite le détecteur à la ligne électrique aérienne 51 en crochetant le tronçon de tige recourbé 7 de l'antenne 2 sur cette ligne.

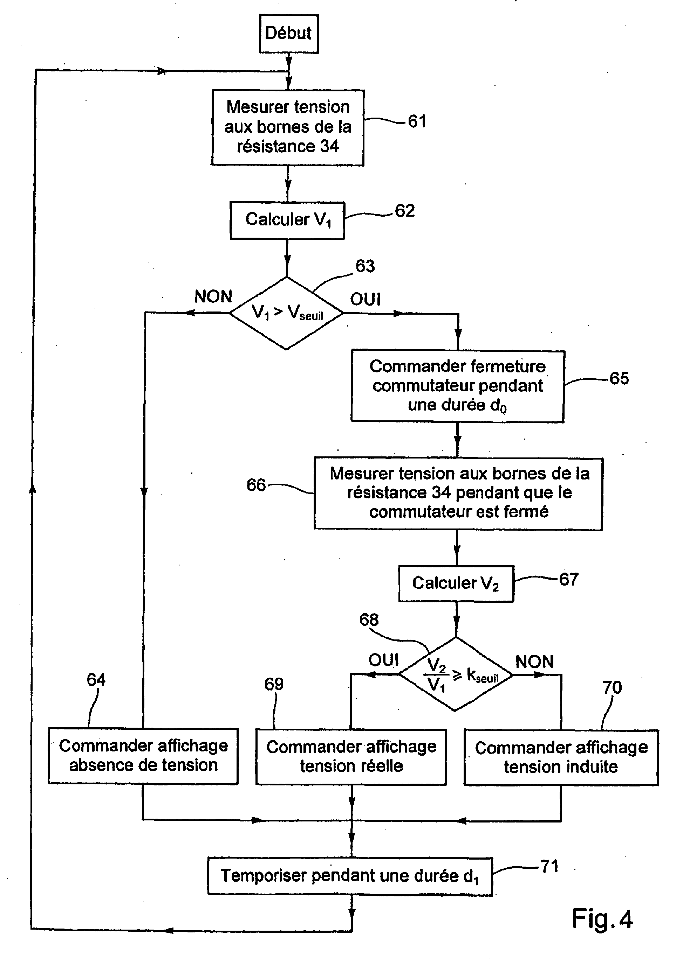

On va maintenant décrire un cycle de détection de tension à l'aide de l'organigramme représenté en figure 4.

Dans une première opération, le micro-contrôleur 37 mesure la tension présente aux bornes de la résistance 34, c'est-à-dire entre ses bornes 47 et 48 (opération 61).

Au cours de cette opération, le commutateur 36 reste en position ouverte, c'est-à-dire dans la position où la liaison électrique entre les points de connexion 45 et 44 au sein du commutateur 36 est ouverte de sorte que la valeur de la résistance entre les points de connexion 31 et 32 est égale à la somme des valeurs des résistances 33, 34 et 35, soit environ 4 MΩ dans l'exemple illustré.

Par un calcul basé sur le principe du pont diviseur de tension, le micro-contrôleur détermine à l'opération 62, sur la base de la tension présente aux bornes de la résistance 34, la valeur de la tension V₁ présente aux bornes du circuit 30, entre les points de connexion 31 et 32.

Le test 63 est ensuite réalisé par le micro-contrôleur 37 pour comparer la tension V₁ ainsi déterminée à une valeur de seuil prédéterminée Vₛₑᵤᵢₗ dépendant de la tension d'alimentation de la ligne électrique aérienne (dans l'exemple illustré, pour une valeur de tension de 1500 V, la tension de seuil est fixée à 400 V). Si V₁ est inférieure à cette valeur de seuil, cela signifie alors qu'aucune tension significative ni induite, ni réelle, n'est présente sur la ligne électrique aérienne et l'opération d'affichage 64 est alors réalisée (clignotement des six diodes vertes 26 du voyant 23 pour indiquer à l'opérateur qu'aucune tension n'est présente).

Le cycle reprend alors à l'opération 61 après une temporisation d'une durée d₁ égale à une seconde dans l'exemple illustré (opération 71). Ce cycle est ainsi réalisé périodiquement à raison d'un cycle par seconde tant qu'aucune tension supérieure à 400 V n'est mesurée sur la ligne 51.

L'opérateur est ainsi informé qu'il peut alors réaliser sans risque, ni pour lui ni pour les installations électriques situées en amont, les opérations de sécurisation élémentaires (mise à la terre de la ligne aérienne).

A l'inverse, si cette tension est supérieure à 400 V, le cycle de détection se poursuit après le test 63 par l'opération 65 où est réalisée par le micro-contrôleur l'envoi d'un signal au commutateur 36 au travers du conducteur disposé entre les points de connexion 46 et 49 pour commander sa fermeture pendant une durée d₀ (ici égale à 50 ms), les points de connexion 45 et 44 étant alors reliés électriquement. Cette fermeture du commutateur entraîne la mise en court-circuit de la résistance 35.

La valeur de la résistance entre les points de connexion 31 et 32 est alors égale à la somme des valeurs des résistances 33 et 34, soit environ 400 kΩ.

Au cours de cet intervalle de temps, une seconde mesure de tension aux bornes de la résistance 34 est réalisée par le micro-contrôleur (opération 66), de façon à déterminer la valeur de la tension V₂ aux bornes des points de connexion 31 et 32 (opération 67).

La valeur de la résistance 34 est choisie de façon à ce que la tension à ses bornes, aussi bien lorsque le commutateur 36 est ouvert que lorsqu'il est fermé, soit incluse dans la plage de fonctionnement du micro-contrôleur.

La durée de 50 ms est choisie de façon à permettre une mesure de tension tout en restant la plus réduite possible afin de minimiser l'énergie dissipée par le passage du courant au travers des résistances 33 et 34 et donc de minimiser la taille des résistances, celles-ci étant dimensionnées en fonction de la puissance dissipée.

Le test 68 de comparaison des tensions V₁ et V₂ est alors réalisé. Si le ratio de V₂ sur V₁ est supérieur ou égal à un coefficient de seuil kₛₑᵤᵢₗ (0.8 dans l'exemple illustré, c'est-à-dire que la valeur V₂ est supérieure ou égale à 80 % de la valeur V₁), alors le micro-contrôleur commande par l'opération 69 l'affichage pour l'opérateur de la présence d'une tension réelle sur la ligne électrique aérienne (allumage en continu des diodes rouges 25 du voyant 22).

A l'inverse, si ce ratio est inférieur à 0.8, alors la chute de tension entre la mesure à plus haute impédance (4 MΩ) et la mesure à plus basse impédance (400 kΩ) permet de conclure que la tension ainsi détectée sur la ligne électrique provient dans ce cas du chargement de cette ligne par des phénomènes capacitifs parasites (tension induite) et non pas du fait que cette ligne est encore alimentée et reliée au réseau électrique (tension réelle).

Le micro-contrôleur commande alors par l'opération 70 l'affichage pour l'opérateur de la présence d'une tension induite sur la ligne électrique aérienne (clignotement de la diode électroluminescente 27 du voyant 24).

Dans le cas où la présence d'une tension induite est indiquée à l'opérateur, celui-ci est informé qu'il n'existe aucun risque à effectuer l'opération de sécurisation consistant à mettre à la terre la ligne électrique aérienne.

A l'inverse, si le détecteur lui indique la présence d'une tension réelle, l'opérateur sera informé qu'il ne peut alors pas procéder à l'étape suivante de sécurisation, évitant ainsi tout risque pour lui et pour le matériel résultant de la mise en court-circuit d'une ligne électrique encore alimentée.

Une fois l'une ou l'autre de ces opérations d'affichage réalisées, le cycle complet de détection reprend au début après une temporisation d'une seconde, le commutateur 36 étant alors revenu dans la position où la liaison électrique entre les points de connexion 45 et 44 est ouverte de façon à retrouver comme résistance totale entre les points de connexion 31 et 32, celle égale à la somme des trois résistances 33, 34 et 35.

Le cycle complet est ainsi reproduit périodiquement à une fréquence d'environ un cycle par seconde.

Dans une variante non illustrée, les mesures de tension V₁ et V₂ sont inversées de sorte que la première mesure de tension est réalisée à la plus basse des valeurs de résistance et la seconde mesure de tension est réalisée à la plus haute de ces valeurs.

Dans une autre variante, convenant à la détection de tensions alternatives, les résistances sont remplacées par des impédances qui ne sont pas purement résistives et/ou le circuit électrique comporte également un pont redresseur.

Dans une autre variante encore le commutateur présente une position stable fermée et est commandé à l'ouverture.

La présente invention n'est pas limitée aux modes de réalisation décrits et représentés mais englobe toute variante d'exécution dans le cadre des revendications.

## Revendications

1. Procédé de détection d'une tension entre une ligne électrique aérienne (51) et un potentiel de référence (50) ; comportant :
- l'étape de relier à ladite ligne électrique aérienne (51) et audit potentiel de référence (50) une impédance de mesure (33, 34, 35) ayant une valeur prédéterminée ;
- l'étape de déterminer (61, 62) la valeur de tension de mesure (V₁) prise par ladite tension alors que ladite ligne électrique (51) est reliée audit potentiel de référence (50) par ladite impédance de mesure (33, 34, 35) ;
- l'étape de comparer (63) ladite valeur de tension de mesure (V₁) à une valeur de seuil prédéterminée ; et
- si ladite valeur de tension de mesure (V₁) est inférieure à ladite valeur de seuil, l'étape d'indiquer l'absence de tension sur ladite ligne (64) :
**caractérisé en ce que** ledit procédé comporte en outre :
- l'étape de relier une impédance supplémentaire (33, 34) ayant une valeur prédéterminée plus basse que ladite valeur de ladite impédance de mesure (33, 34, 35) à ladite ligne électrique aérienne (51) et audit potentiel de référence (50) à un moment distinct de ladite étape de détermination (61, 62) de ladite valeur de tension de mesure (V₁) ;
- l'étape de déterminer (66, 67) la valeur de tension supplémentaire (V₂) prise par ladite tension alors que ladite ligne électrique (51) est reliée audit potentiel de référence (50) par ladite impédance supplémentaire (33, 34) ;
- l'étape de comparer (68) la valeur de tension de mesure (V₁) à la valeur de tension supplémentaire (V₂) ; et
- si le ratio de ladite valeur de tension supplémentaire (V₂) sur ladite valeur de tension de mesure (V₁) est supérieur ou égal à un coefficient prédéterminé, l'étape d'indiquer la présence d'une tension réelle sur ladite ligne (69) alors que si ledit ratio est inférieur audit coefficient prédéterminé, l'étape d'indiquer la présence d'une tension induite sur ladite ligne (70).

2. Procédé selon la revendication 1, **caractérisé en ce que** l'on sélectionne comme dite impédance de mesure (33, 34, 35) une impédance dont la valeur est supérieure à 1 MΩ.

3. Procédé selon l'une quelconque des revendications 1 ou 2, **caractérisé en ce que** l'on sélectionne comme dite impédance supplémentaire (33, 34) une impédance dont la valeur est au moins dix fois plus petite que ladite valeur de ladite impédance de mesure (33, 34, 35).

4. Procédé selon l'une quelconque des revendications 1 à 3, **caractérisé en ce que** l'étape de relier ladite impédance de mesure (33, 34, 35) comporte l'étape de sélectionner comme impédance de mesure une impédance comportant au moins deux résistances (33, 34, 35) disposées en série.

5. Procédé selon la revendication 4, **caractérisé en ce que** l'étape de déterminer (61, 62) la valeur de tension de mesure (V₁) prise par ladite tension alors que ladite ligne électrique (51) est reliée audit potentiel de référence (50) par ladite impédance de mesure (33, 34, 35) comporte l'étape de mesurer (61) la tension aux bornes d'une desdites résistances (34) ;

6. Procédé selon l'une quelconque des revendications 4 ou 5, **caractérisé en ce qu'**il comporte l'étape de mettre en court-circuit au moins l'une desdites résistances (35) de ladite impédance de mesure (33, 34, 35) pour former ladite impédance supplémentaire (33, 34).

7. Procédé selon la revendication 6, **caractérisé en ce que** l'étape de déterminer (66, 67) la valeur de tension supplémentaire (V₂) prise par ladite tension alors que ladite ligne électrique (51) est reliée audit potentiel de référence (50) par ladite impédance supplémentaire (33, 34) comporte l'étape de mesurer (66) la tension aux bornes d'une desdites résistances (34), distincte de chaque résistance mise en court-circuit (35) ;

8. Procédé selon l'une quelconque des revendications 6 ou 7, **caractérisé en ce que** l'étape de mettre en court-circuit au moins l'une desdites résistances (35) comporte :
- l'étape de sélectionner un organe de commutation (36) ;
- l'étape de disposer ledit organe de commutation (36) en parallèle de cette résistance (35) à mettre en court-circuit ; et
- l'étape de commander la fermeture dudit organe de commutation (36).

9. Procédé selon la revendication 8, **caractérisé en ce que** l'on sélectionne comme dit organe de commutation (36) un organe adapté à supporter une tension supérieure à 1500 Volts en position ouverte.

10. Procédé selon la revendication 9, **caractérisé en ce que** la valeur ou la somme des valeurs de chaque résistance (34) à mettre en court-circuit est supérieure à 1 MΩ.

11. Procédé selon l'une quelconque des revendications 1 à 10, **caractérisé en ce que** l'on relie ladite impédance supplémentaire (33, 34) à ladite ligne électrique aérienne (51) et audit potentiel de référence (50) pendant une durée inférieure à 200 ms.

12. Détecteur de tension convenant à la mise en oeuvre du procédé selon l'une quelconque des revendications 1 à 11, comportant :
- une impédance de mesure (33, 34, 35) ;
- des moyens de liaison (2, 5) de ladite impédance de mesure (33, 34, 35) à ladite ligne électrique aérienne (51) et audit potentiel de référence (50) ;
- des moyens de détermination et de comparaison (36, 37) adaptés à déterminer la valeur de tension de mesure (V₁) prise par ladite tension alors que ladite ligne électrique (51) est reliée audit potentiel de référence (50) par ladite impédance de mesure (33, 34, 35) et à comparer ladite valeur de tension de mesure (V₁) à une valeur de seuil prédéterminée ; et
- des moyens de signalisation (22, 23, 37) adaptés à indiquer l'absence de tension sur ladite ligne (51) si ladite valeur de tension de mesure (V₁) est inférieure à ladite valeur de seuil ;
**caractérisé en ce qu'**il comporte en outre :
- une impédance supplémentaire (33, 34) ayant une valeur prédéterminée plus basse que ladite valeur de ladite impédance de mesure (33, 34, 35) ;
- des moyens de liaison (2, 5) de ladite impédance supplémentaire (33, 34) à ladite ligne électrique aérienne (51) et audit potentiel de référence (50) ;
et **en ce que** :
- lesdits moyens de détermination et de comparaison (36, 37) sont également adaptés à :
▪ relier ladite impédance supplémentaire (33, 34) à ladite ligne électrique aérienne (51) et audit potentiel de référence (50) à un moment distinct du moment où lesdits moyens de détermination et de comparaison (36, 37) déterminent la valeur de ladite tension de mesure (V1) ;
▪ déterminer la valeur de tension supplémentaire (V₂) prise par ladite tension alors que ladite ligne électrique (51) est reliée audit potentiel de référence (50) par ladite impédance supplémentaire (33, 34) ; et à
▪ comparer ladite valeur de tension de mesure (V₁) à ladite valeur de tension supplémentaire (V₂) ; et
- lesdits moyens de signalisation (22, 23, 24, 37) sont également adaptés à indiquer, si le ratio de ladite valeur de tension supplémentaire (V2) sur ladite valeur de tension de mesure (V1) est supérieur ou égal à un coefficient prédéterminé, la présence d'une tension réelle sur ladite ligne (69), et à indiquer, si ledit ratio est inférieur audit coefficient prédéterminé, la présence d'une tension induite sur ladite ligne (70).

13. Détecteur selon la revendication 12, **caractérisé en ce que** ladite impédance de mesure comporte au moins deux résistances (33, 34, 35) disposées en série.

14. Détecteur selon la revendication 13, **caractérisé en ce que** lesdits moyens de détermination et de comparaison (36, 37) comportent un organe de commutation (36) adapté à prendre une position où il met en court-circuit au moins l'une des dites résistances (35) pour former ladite impédance supplémentaire (33, 34).

15. Détecteur selon la revendication 14, **caractérisé en ce que** lesdits moyens de détermination et de comparaison (36, 37) comportent un micro-contrôleur (37) adapté à mesurer la tension aux bornes d'une desdites résistances (34).

16. Détecteur selon l'une quelconque des revendications 12 à 15, **caractérisé en ce que** lesdits moyens de liaison (2, 5) de ladite impédance de mesure (33, 34, 35) à ladite ligne électrique aérienne (51) et audit potentiel de référence (50) et lesdits moyens de liaison (2, 5) de ladite impédance supplémentaire (33, 34) à ladite ligne électrique aérienne (51) et audit potentiel de référence (50) sont identiques.

17. Détecteur selon la revendication 16, **caractérisé en ce que** lesdits moyens de liaison (2, 5) comportent une antenne (2) et une platine aimantée (15).

18. Détecteur selon l'une quelconque des revendications 1 à 17, **caractérisé en ce que** lesdits moyens de signalisation (22, 23, 24, 37) comportent un premier voyant lumineux (23) adapté à prendre un état prédéterminé pour indiquer l'absence de tension, un deuxième voyant lumineux (24) adapté à prendre un état prédéterminé pour indiquer la présence d'une tension induite, et un troisième voyant lumineux (22) adapté à prendre un état prédéterminé pour indiquer la présence d'une tension réelle.

## Patentansprüche

1. Verfahren zum Prüfen einer Spannung zwischen einer elektrischen Freileitung (51) und einem Bezugspotential (50), umfassend:
- den Schritt des Verbindens einer Messimpedanz (33, 34, 35) mit einem vorbestimmten Wert mit der elektrischen Freileitung (51) und mit dem Bezugspotential (50);
- den Schritt des Ermittelns (61, 62) des Messspannungswertes (V₁), der von der Spannung abgegriffen wird, während die elektrische Freileitung (51) über die Messimpedanz (33, 34, 35) mit dem Bezugspotential (50) verbunden ist;
- den Schritt des Vergleichens (63) des Messspannungswertes (V₁) mit einem vorbestimmten Schwellenwert; und
- wenn der Messspannungswert (V₁) geringer als der Schwellenwert ist, den Schritt des Hinweisens auf das Fehlen von Spannung an der Leitung (64);
**dadurch gekennzeichnet, dass** das Verfahren ferner umfasst:
- den Schritt des Verbindens einer zusätzlichen Impedanz (33, 34) mit einem vorbestimmten Wert, der niedriger als der Wert der Messimpedanz (33, 34, 35) ist, mit der elektrischen Freileitung (51) und mit dem Bezugspotential (50) zu einem Zeitpunkt, der sich von dem Schritt des Ermittelns (61, 62) des Messspannungswertes (V₁) unterscheidet;
- den Schritt des Ermittelns (66, 67) des zusätzlichen Spannungswertes (V₂), der von der Spannung abgegriffen wird, während die elektrische Freileitung (51) über die zusätzliche Impedanz (33, 34) mit dem Bezugspotential (50) verbunden ist;
- den Schritt des Vergleichens (68) des Messspannungswertes (V₁) mit dem zusätzlichen Spannungswert (V₂); und
- wenn das Verhältnis des zusätzlichen Spannungswertes (V₂) zum Messspannungswert (V₁) höher oder gleich einem vorbestimmten Koeffizienten ist, den Schritt des Hinweisens auf das Vorhandensein einer realen Spannung an der Leitung (69), wenn dagegen das Verhältnis geringer als der vorbestimmte Koeffizient ist, den Schritt des Hinweisens auf das Vorhandensein einer induzierten Spannung an der Leitung (70).

2. Verfahren nach Anspruch 1, **dadurch gekennzeichnet, dass** als die Messimpedanz (33, 34, 35) eine Impedanz gewählt wird, deren Wert höher als 1 MΩ ist.

3. Verfahren nach einem der Ansprüche 1 oder 2, **dadurch gekennzeichnet, dass** als die zusätzliche Impedanz (33, 34) eine Impedanz gewählt wird, deren Wert mindestens zehnmal kleiner als der Wert der Messimpedanz (33, 34, 35) ist.

4. Verfahren nach einem der Ansprüche 1 bis 3, **dadurch gekennzeichnet, dass** der Schritt des Verbindens der Messimpedanz (33, 34, 35) den Schritt des Auswählens einer Impedanz mit zumindest zwei in Reihe geschalteten Widerständen (33, 34, 35) als Messimpedanz umfasst.

5. Verfahren nach Anspruch 4, **dadurch gekennzeichnet, dass** der Schritt des Ermittelns (61, 62) des Messspannungswertes (V₁), der von der Spannung abgegriffen wird, während die elektrische Freileitung (51) über die Messimpedanz (33, 34, 35) mit dem Bezugspotential (50) verbunden ist, den Schritt des Messens (61) der Spannung an den Anschlussklemmen eines der Widerstände (34) umfasst.

6. Verfahren nach einem der Ansprüche 4 oder 5, **dadurch gekennzeichnet, dass** es den Schritt des Kurzschließens von zumindest einem der Widerstände (35) der Messimpedanz (33, 34, 35) zum Bilden der zusätzlichen Impedanz (33, 34) umfasst.

7. Verfahren nach Anspruch 6, **dadurch gekennzeichnet, dass** der Schritt des Ermittelns (66, 67) des zusätzlichen Spannungswertes (V₂), der von der Spannung abgegriffen wird, während die elektrische Freileitung (51) über die zusätzliche Impedanz (33, 34) mit dem Bezugspotential (50) verbunden ist, den Schritt des Messens (66) der Spannung an den Anschlussklemmen eines der Widerstände (34) umfasst, der sich von jedem kurzgeschlossenen Widerstand (35) unterscheidet.

8. Verfahren nach einem der Ansprüche 6 oder 7, **dadurch gekennzeichnet, dass** der Schritt des Kurzschließens von zumindest einem der Widerstände (35) umfasst:
- den Schritt des Auswählens eines Schaltorgans (36);
- den Schritt des Anordnens der Schaltorgans (36) parallel zu diesem kurzzuschließenden Widerstand (35); und
- den Schritt des Steuerns des Schließens von dem Schaltorgan (36).

9. Verfahren nach Anspruch 8, **dadurch gekennzeichnet, dass** als das Schaltorgan (36) ein Organ gewählt wird, das dazu geeignet ist, einer Spannung höher als 1500 Volt in Offenstellung standzuhalten.

10. Verfahren nach Anspruch 9, **dadurch gekennzeichnet, dass** der Wert oder die Summe der Werte eines jeden kurzzuschließenden Widerstands (34) höher als 1 MΩ ist.

11. Verfahren nach einem der Ansprüche 1 bis 10, **dadurch gekennzeichnet, dass** die zusätzliche Impedanz (33, 34) mit der elektrischen Freileitung (51) und mit dem Bezugspotential (50) für eine Zeitdauer von unter 200 ms verbunden wird.

12. Spannungsprüfer zum Durchführen des Verfahrens nach einem der Ansprüche 1 bis 11, umfassend:
- eine Messimpedanz (33, 34, 35);
- Verbindungsmittel (2, 5) zum Verbinden der Messimpedanz (33, 34, 35) mit der elektrischen Freileitung (51) und mit dem Bezugspotential (50);
- Ermittlungs- und Vergleichsmittel (36, 37), die dazu geeignet sind, den Messspannungswert (V₁) zu ermitteln, der von der Spannung abgegriffen wird, während die elektrische Freileitung (51) über die Messimpedanz (33, 34, 35) mit dem Bezugspotential (50) verbunden ist, und den Messspannungswert (V₁) mit einem vorbestimmten Schwellenwert zu vergleichen; und
- Signalmittel (22, 23, 37), die dazu geeignet sind, auf das Fehlen von Spannung an der Leitung (51) hinzuweisen, wenn der Messspannungswert (V₁) geringer als der Schwellenwert ist;
**dadurch gekennzeichnet, dass** er ferner umfasst:
- eine zusätzliche Impedanz (33, 34) mit einem vorbestimmten Wert, der niedriger als der Wert der Messimpedanz (33, 34, 35) ist;
- Verbindungsmittel (2, 5) zum Verbinden der zusätzlichen Impedanz (33, 34, 35) mit der elektrischen Freileitung (51) und mit dem Bezugspotential (50);
und dadurch, dass:
- die Ermittlungs- und Vergleichsmittel (36, 37) auch dazu geeignet sind,
• die zusätzliche Impedanz (33, 34) mit der elektrischen Freileitung (51) und mit dem Bezugspotential (50) zu einem Zeitpunkt zu verbinden, der sich von dem Zeitpunkt unterscheidet, an dem die Ermittlungs- und Vergleichsmittel (36, 37) den Wert der Messspannung (V₁) ermitteln;
• den zusätzlichen Spannungswert (V₂) zu ermitteln, der von der Spannung abgegriffen wird, während die elektrische Freileitung (51) über die zusätzliche Impedanz (33, 34) mit dem Bezugspotential (50) verbunden ist; und
• den Messspannungswert (V₁) mit dem zusätzlichen Spannungswert (V₂) zu vergleichen; und
- die Signalmittel (22, 23, 24, 37) auch dazu geeignet sind, auf das Vorhandensein einer realen Spannung an der Leitung (69) dann hinzuweisen, wenn das Verhältnis des zusätzlichen Spannungswert (V₂) zum Messspannungswert (V₁) höher oder gleich einem vorbestimmten Koeffizienten ist, und auf das Vorhandensein einer induzierten Spannung an der Leitung (70) dann hinzuweisen, wenn das Verhältnis geringer als der vorbestimmte Koeffizient ist.

13. Spannungsprüfer nach Anspruch 12, **dadurch gekennzeichnet, dass** die Messimpedanz zumindest zwei in Reihe geschaltete Widerstände (33, 34, 35) aufweist.

14. Spannungsprüfer nach Anspruch 13, **dadurch gekennzeichnet, dass** die Ermittlungs- und Vergleichsmittel (36, 37) ein Schaltorgan (36) aufweisen, das dazu geeignet ist, eine Stellung einzunehmen, in der es zumindest einen der Widerstände (35) kurzschließt, um die zusätzliche Impedanz (33, 34) zu bilden.

15. Spannungsprüfer nach Anspruch 14, **dadurch gekennzeichnet, dass** die Ermittlungs- und Vergleichsmittel (36, 37) einen Mikrokontroller (37) umfassen, der dazu geeignet ist, die Spannung an den Anschlussklemmen eines der Widerstände (34) zu messen.

16. Spannungsprüfer nach einem der Ansprüche 12 bis 15, **dadurch gekennzeichnet, dass** die Verbindungsmittel (2, 5) zum Verbinden der Messimpedanz (33, 34, 35) mit der elektrischen Freileitung (51) und mit dem Bezugspotential (50) und die Verbindungsmittel (2, 5) zum Verbinden der zusätzlichen Impedanz (33, 34) mit der elektrischen Freileitung (51) und mit dem Bezugspotential (50) identisch sind.

17. Spannungsprüfer nach Anspruch 16, **dadurch gekennzeichnet, dass** die Verbindungsmittel (2, 5) eine Antenne (2) und eine Magnetplatte (15) aufweisen.

18. Spannungsprüfer nach einem der Ansprüche 1 bis 17, **dadurch gekennzeichnet, dass** die Signalmittel (22, 23, 24, 37) eine erste Leuchtanzeige (23) umfassen, die dazu geeignet ist, einen vorbestimmten Zustand einzunehmen, um auf das Fehlen von Spannung hinzuweisen, sowie eine zweite Leuchtanzeige (24), die dazu geeignet ist, einen vorbestimmten Zustand einzunehmen, um auf das Vorhandensein einer induzierten Spannung hinzuweisen, und eine dritte Leuchtanzeige (22), die dazu geeignet ist, einen vorbestimmten Zustand einzunehmen, um auf das Vorhandensein einer realen Spannung hinzuweisen.

## Claims

1. A method of detecting a voltage between an overhead electric line (51) and a reference potential (50); comprising:
- the step of connecting to said overhead electric line (51) and to said reference potential (50) a measurement impedance (33, 34, 35) having a predetermined value;
- the step of determining (61, 62) the measurement voltage value (V₁) taken by said voltage when said electric line (51) is connected to said reference potential (50) by said measurement impedance (33, 34, 35);
- the step of comparing (63) said measurement voltage value (V₁) with a predetermined threshold value; and
- if said measurement voltage value (V₁) is less than said threshold value, the step of indicating the absence of voltage on said line (64);
**characterized in that** said method further comprises:
- the step of connecting an additional impedance (33, 34) having a lower predetermined value than said value of said measurement impedance (33, 34, 35) to said overhead electric line (51) and to said reference potential (50) at a distinct time of said step (61, 62) of determining said measurement voltage value (V₁);
- the step of determining (66, 67) the additional voltage value (V₂) taken by said voltage when said electric line (51) is connected to said reference potential (50) by said additional impedance (33, 34);
- the step of comparing (68) the measurement voltage value (V₁) with the additional voltage value (V₂); and
if the ratio of said additional voltage value (V₂) to said measurement voltage value (V₁) is greater than or equal to a predetermined coefficient, the step of indicating the presence of a real voltage on said line (69) whereas if said ratio is less than said predetermined coefficient, the step of indicating the presence of an induced voltage on said line (70).

2. A method according to claim 1, **characterized in that** it comprises selecting as said measurement impedance (33, 34, 35) an impedance of which the value is greater than 1 MΩ.

3. A method according to any one of claims 1 or 2, **characterized in that** it comprises selecting as said additional impedance (33, 34) an impedance of which the value is at least ten times smaller than said value of said measurement impedance (33, 34, 35).

4. A method according to any one of claims 1 to 3, **characterized in that** the step of connecting said measurement impedance (33, 34, 35) comprises the step of selecting as measurement impedance an impedance comprising at least two resistors (33, 34, 35) disposed in series.

5. A method according to claim 4, **characterized in that** the step of determining (61, 62) the measurement voltage value (V₁) taken by said voltage when said electric line (51) is connected to said reference potential (50) by said measurement impedance (33, 34, 35) comprises the step of measuring (61) the voltage at the terminals of one of said resistors (34);

6. A method according to any one of claims 4 or 5, **characterized in that** it comprises the step of short-circuiting at least one of said resistors (35) of said measurement impedance (33, 34, 35) to form said additional impedance (33, 34).

7. A method according to claim 6, **characterized in that** the step of determining (66, 67) the additional voltage value (V₂) taken by said voltage when said electric line (51) is connected to said reference potential (50) by said additional impedance (33, 34) comprises the step of measuring (66) the voltage at the terminals of one of said resistors (34), that is distinct from each shortcircuited resistor (35);

8. A method according to any one of claims 6 or 7, **characterized in that** the step of short-circuiting at least one of said resistors (35) comprises:
- the step of selecting a switching member (36);
- the step of disposing said switching member (36) in parallel with said resistor (35) to short-circuit; and
- the step of actuating the closure of said switching member (36).

9. A method according to claim 8, **characterized in that** it comprises selecting as said switching member (36) a member adapted to bear a voltage greater than 1500 Volts in open position.

10. A method according to claim 9, **characterized in that** the value or the sum of the values of each resistor (34) to short-circuit is greater than 1 MΩ.

11. A method according to any one of claims 1 to 10, **characterized in that** said additional impedance (33, 34) is connected to said overhead electric line (51) and to said reference potential (50) for a time less than 200 ms.

12. A voltage detector suitable for the implementation of the method according to any one of claims 1 to 11, comprising:
- a measurement impedance (33, 34, 35);
- means (2, 5) for connecting said measurement impedance (33, 34, 35) to said overhead electric line (51) and to said reference potential (50);
- means for determining and comparing (36, 37) adapted to determine the measurement voltage value (V₁) taken by said voltage when said electric line (51) is connected to said reference potential (50) by said measurement impedance (33, 34, 35) and to compare said measurement voltage value (V₁) to a predetermined threshold value; and
- signaling means (22, 23, 37) adapted to indicate the absence of voltage on said line (51) if said measurement voltage value (V₁) is less than said threshold value;
**characterized in that** it further comprises:
- an additional impedance (33, 34) having a lower predetermined value than said measurement impedance value (33, 34, 35);
- means (2, 5) for connecting said additional impedance (33, 34) to said overhead electric line (51) and to said reference potential (50);
and **in that**:
- said means (36, 37) for determining and comparing are also adapted to:
• connect said additional impedance (33, 34) to said overhead electric line (51) and to said reference potential (50) at a time distinct from the time at which said means (36, 37) for determining and comparing determine the value of said measurement voltage (V₁);
• determine the additional voltage value (V₂) taken by said voltage when said electric line (51) is connected to said reference potential (50) by said additional impedance (33, 34); and to
• compare said measurement voltage value (V₁) to said additional voltage value (V₂);
- said signaling means (22, 23, 24, 37) are also adapted to indicate, if the ratio of said additional voltage value (V₂) to said measurement voltage value (V₁) is greater than or equal to a predetermined coefficient, the presence of a real voltage on said line (69), and to indicate, if said ratio is less than said predetermined coefficient, the presence of an induced voltage on said line (70).

13. A detector according to claim 12, **characterized in that** said measurement impedance comprises at least two resistors (33, 34, 35) disposed in series.

14. A detector according to claim 13, **characterized in that** said means (36, 37) for determining and comparing comprise a switching member (36) adapted to take a position in which it short-circuits at least one of said resistors (35) to form said additional impedance (33, 34).

15. A detector according to claim 14, **characterized in that** said means (36, 37) for determining and comparing comprise a microcontroller (37) adapted to measure the voltage at the terminals of said resistors (34).

16. A detector according to any one of claims 12 to 15, **characterized in that** said connecting means (2, 5) for connecting said measurement impedance (33, 34, 35) to said overhead electric line (51) and to said reference potential (50) and said means (2, 5) for connecting said additional impedance (33, 34) to said overhead electrical line (51) and to said reference potential (50) are identical.

17. A detector according to claim 16, **characterized in that** said connecting means (2, 5) comprise an antenna (2) and a magnetic plate (15).

18. A detector according to any one of claims 1 to 17, **characterized in that** said signaling means (22, 23, 24, 37) comprise a first indicator light (23) adapted to take a predetermined state to indicate the absence of voltage, a second indicator light (24) adapted to take a predetermined state to indicate the presence of an induced voltage, and a third indicator light (22) adapted to take a predetermined state to indicate the presence of a real voltage.
